# EUROPÄISCHE PATENTANMELDUNG

(11) **EP 2 775 809 A2**
(43) Veröffentlichungstag der Anmeldung: **10.09.2014**
(21) Anmeldenummer: 14000545.5
(22) Anmeldetag: 15.02.2014
(51) Int. Cl.: H05K 5/00

(54) **Gehäuse zur Aufnahme einer Leiterplatte mit mindestens einer Steckerschnittstelle, elektronisches Modul mit derartigem Gehäuse, Kraftfahrzeug damit und Verfahren zum Herstellen eines derartigen Gehäuses bzw. elektronischen Moduls**

(30) Priorität: 05.03.2013 DE 102013003800
(71) Anmelder: WABCO GmbH, 30453 Hannover (DE)
(72) Erfinder: Bolik, Thomas, 30559 Hannover (DE); Brammer, Christian, 29303 Bergen (DE); Heider, Joachim, 31226 Peine (DE); Rüter, Rodmar, 30938 Burgwedel (DE)

(57) **Zusammenfassung**

Die Erfindung betrifft ein Gehäuse zur Aufnahme einer Leiterplatte mit mindestens einer Steckerschnittstelle 20 für eine elektronische Anbindung der Leiterplatte an mindestens eine elektrische Komponente. Dazu ist erfindungsgemäß die Steckerschnittstelle 20 an eine Innenwand 6 des Gehäuses angebracht. Ferner ist die Steckerschnittstelle 20 mit mindestens einem gebogenen Kontaktelement 8 ausgestaltet, wobei das Kontaktelement 8 zwei Kontaktabschnitte 10, 12 aufweist. Der erste Kontaktabschnitt 10 dient der elektronischen Anbindung an die Leiterplatte und der zweite Kontaktabschnitt 12 bildet einen Stecker.

Ferner betrifft die Erfindung ein elektronisches Modul mit einem derartigen Gehäuse, ein Kraftfahrzeug damit, sowie ein Herstellungsverfahren eines erfindungsgemäßen Gehäuses bzw. eines erfindungsgemäßen elektronischen Moduls.

## Beschreibung

Die Erfindung betrifft ein Gehäuse zur Aufnahme einer Leiterplatte mit mindestens einer Steckerschnittstelle, ein elektrisches Modul, insbesondere ein elektronisches Steuergerät eines Kraftfahrzeugs, mit einem derartigen Gehäuse sowie ein Kraftfahrzeug mit einem derartigen Modul und/oder Gehäuse. Weiterhin betrifft die Erfindung ein Herstellungsverfahren für ein derartiges Gehäuse sowie ein Herstellungsverfahren für ein derartiges elektronisches Modul.

In der Kraftfahrzeugtechnik sind Komponenten, wie bspw. Getriebe-, Motorenoder Bremssysteme, herkömmlicherweise mittels einer entsprechenden Steuerelektronik elektronisch gesteuert. Dabei werden vermehrt mechatronische Steuerungen, welche die Steuerelektronik mit den zugehörigen elektronischen Komponenten, wie Sensoren und/oder Ventilen, für das Getriebe, den Motor oder das Bremssystem verbinden, eingesetzt. Somit weisen derartige mechatronische Steuerungen bzw. Steuergeräte eine Vielzahl an elektronischen Komponenten auf, die mit anderen Komponenten in Verbindung stehen.

Um die Steuerelektronik und die elektronischen Komponenten vor Umwelteinflüssen und mechanischen, thermischen sowie chemischen Beanspruchungen zu schützen, sind die Steuerelektronik und die elektronischen Komponenten in spezielle Gehäuse angeordnet. Diese sind jedoch im allgemeinen komplex aufgebaut und erfordern durch die Anbringung und Kontaktierung von weiteren Komponenten, wie bspw. Magnetspulen und/oder Drucksensoren, einen relativ großen Bauraum.

Die elektrische Kontaktierung der Komponenten erfolgt dabei üblicherweise mittels einer oder mehrerer Steckerverbindungen auf einer Leiterplatte oder eines anderen Schaltungsträgers, insbesondere einer ECU-Platine mit elektronischer Steuereinheit. Ein derartiger auf der Leiterplatte gelöteter Stecker benötigt jedoch eine ausreichend hohe Bauweise des Gehäuses. Zudem weisen bekannte Anschlusskonstruktionen mehrere Teile auf, wodurch zusätzliche Material- und Prozesskosten bei der Herstellung entstehen.

Der Erfindung liegt daher die Aufgabe zugrunde, eine kostengünstige und platzsparende Steckerschnittstelle innerhalb eines Gehäuses, insbesondere innerhalb einer einseitig offenen Gehäusewanne, zu schaffen.

Die Erfindung löst diese Aufgabe mit einem Gehäuse zur Aufnahme einer Leiterplatte mit mindestens einer Steckerschnittstelle nach Anspruch 1, mit einem elektronischen Modul mit einem Gehäuse und mindestens einer Leiterplatte nach Anspruch 11, mit einem Kraftfahrzeug nach Anspruch 13, mit einem Verfahren zum Herstellen eines Gehäuses nach Anspruch 14 sowie mit einem Verfahren zum Herstellen eines elektronischen Moduls nach Anspruch 15.

Insbesondere löst die Erfindung die Aufgabe mit einem Gehäuse zur Aufnahme einer Leiterplatte mit mindestens einer Steckerschnittstelle für eine elektronische Anbindung der Leiterplatte an mindestens eine elektrische Komponente. Dabei weist die Steckerschnittstelle mindestens ein Kontaktelement auf. Bevorzugt sind jedoch mehrere, von einander isolierte, leitfähige Kontaktelemente zu einer Steckerschnittstelle angeordnet.

Die Steckerschnittstelle ist erfindungsgemäß an einer Innenwand des Gehäuses angeordnet. Unter einer Innenwand wird dabei jedwede innenliegende, raumbegrenzende Wand des Gehäuses verstanden, wie bspw. eine Seitenwand, der Gehäuseboden oder eine in dem Gehäuse liegende Trennwand.

Das Kontaktelement weist an den freien Enden der Schenkel jeweils einen Kontaktabschnitt auf, wobei der erste Kontaktabschnitt der elektronischen Anbindung an die Leiterplatte dient, und der zweite Kontaktabschnitt einen Stecker bildet. Bevorzugt ist das Kontaktelement U-förmig ausgebildet, so dass die Kontaktabschnitte im Wesentlichen parallel zueinander verlaufen. Das Kontaktelement kann jedoch auch andere Formen aufweisen, so dass die Kontaktabschnitte beispielsweise leicht winkelversetzt zueinander angeordnet sind. Ferner kann das Kontaktelement auch V-förmig oder W-förmig ausgebildet sein. Vorzugsweise stehen die freien Enden der Schenkel in einem Winkel von höchstens 90 °, bevorzugt von höchstens 45°, weiter bevorzugt von höchstens 30° zueinander.

Das Integrieren der Steckerschnittstelle in das Gehäuse, wie es die Erfindung vorsieht, ermöglicht vorteilhaft eine elektronische Anbindung der Leiterplatte an eine elektrische Komponente ohne Verwendung eines auf die Leiterplatte gelöteten Steckers bzw. einer auf der Leiterplatte angeordneten sonstigen Anschlusskonstruktion.

Die gebogene Form des Kontaktelementes bzw. der Kontaktelemente der Steckerschnittstelle sorgt für eine geringe Bauhöhe des Gehäuses, wodurch eine platzsparende Ausgestaltung des Gehäuses als einseitig offene Gehäusewanne bzw. Steckerwanne möglich ist. Mittels eines derartigen erfindungsgemäßen Gehäuses lassen sich somit vorteilhaft Material- und Montagekosten für einen Deckel inklusive Dichtung einsparen. Ferner lassen sich vorteilhaft Material- und Prozesskosten durch Bestückung und Lötung eines Steckers auf der Leiterplatte bei der Herstellung einsparen.

Schließlich wirken vorteilhaft keine Steck- und Ziehkräfte auf die Leiterplatte, da aufgrund des erfindungsgemäßen Gehäuses kein Stecker auf der Leiterplatte notwendig ist, um eine Steckverbindung zu weiteren elektronischen Komponenten herzustellen.

Das erfindungsgemäße Gehäuse ist somit besonders vorteilhaft kostengünstig und platzsparend herzustellen. Ein weiterer Vorteil des erfindungsgemäßen Gehäuses ist die Unabhängigkeit der Leiterplatte von dem verwendeten Steckerdesign, da die Steckerschnittstelle in das Gehäuse integriert ist.

Gemäß einer bevorzugten Ausführungsform der Erfindung ist mindestens ein Kontaktabschnitt des Kontaktelementes als ein Kontaktstift ausgebildet, insbesondere als ein rund oder rechteckig ausgeführter Kontaktstift. Sind innerhalb der Steckerschnittstelle mehrere Kontaktelemente nebeneinander angeordnet, bilden die stiftförmigen Kontaktabschnitte ganze Stiftleisten, um eine elektrische Verbindung mit vielen Kontakten herzustellen.

Die Ausgestaltung des ersten Kontaktabschnittes des Kontaktelementes als Kontaktstift hat dabei den Vorteil, dass der Kontaktstift in einem Montageschritt in ein dafür vorgesehenes Loch in der Leiterplatte eingeführt werden kann.

Die Ausgestaltung des zweiten Kontaktabschnittes des Kontaktelementes als Kontaktstift hat dabei den Vorteil, dass eine Steckverbindung einfach mittels einer entsprechenden Buchse, bzw. Buchsenleiste bei als Stiftleisten ausgebildeten Kontaktelementen, herstellbar ist.

In einer weiteren bevorzugten Ausführungsform der Erfindung ist der erste Kontaktabschnitt des Kontaktelementes als Einpressstift ausgebildet. Dadurch kann vorteilhaft eine einfache Einpresstechnik als lötfreie Anschlusstechnik der Leiterplatte an die Steckerschnittstelle genutzt werden, bei der der Einpressstift in ein metallisiertes Loch der Leiterplatte gepresst wird. Dabei kann der Einspressstift massiv ausgeführt sein oder aber eine Verformzone aufweisen, welche beim Einpressen zusammengedrückt wird. Über derartige erfindungsgemäße Einpressstifte ist vorteilhaft eine einfache und sichere elektrische Verbindung hergestellt, die kostengünstig ist und die Leiterplatte thermisch nicht belastet.

Eine weitere bevorzugte Ausführungsform der Erfindung sieht eine Ausgestaltung der Steckerschnittstelle mit einem elektrisch nicht leitenden Stützteil vor, in welchem der erste Kontaktabschnitt des Kontaktelementes eingebracht ist. Bevorzugt weist das Stützteil eine Auflagefläche zur Auflage der Leiterplatte auf.

Das Stützteil und die Auflagefläche dienen als stabilisierende Abstandshalter und sorgen vorteilhaft für eine fehlerfreie Montage und für eine genaue Positionierung der Leiterplatte innerhalb des Gehäuses. Bei mehreren nebeneinander angeordneten Kontaktelementen ermöglicht die Auflagefläche vorteilhaft eine gleichmäßige Eindringtiefe der Einpressstifte in die Leiterplatte, wodurch vorteilhaft eine sichere und stabile Kontaktierung gewährleistet ist.

Ferner ist die Steckerschnittstelle mit einem elektrischen nichtleitenden Steckergehäuse ausgestaltet, in der der zweite Kontaktabschnitt eingebracht ist. Das Steckergehäuse dient dabei vorteilhaft zur Aufnahme eines Gegensteckers zur Bildung einer elektrischen Steckverbindung. Um die mechanische Stabilität der Steckverbindung zu erhöhen, kann das Steckergehäuse mit einer Verriegelungsvorrichtung versehen werden, wie bspw. einer Snap-Technik, die sich leicht wieder lösen lässt.

Dadurch, dass das Kontaktelement in dem Stützteil sowie in dem Steckergehäuse eingebracht ist, ist das Kontaktelement bis auf die als Kontaktabschnitte bezeichneten freien Enden der U-Schenkel vorteilhaft von einer elektrisch nicht leitenden Kunststoffumspritzung umgeben.

Gemäß einer weiteren bevorzugten Ausführungsform der Erfindung ist das erfindungsgemäße Gehäuse einstückig mit dem Stützteil und dem Steckergehäuse ausgebildet. Bevorzugt wird das Kontaktelement bereits bei der Herstellung des Gehäuses mittels eines geeigneten Gussverfahrens in das Stützteil und das Steckergehäuse eingebracht. Durch eine derartige Ausbildung von Stützteil, Steckergehäuse und Gehäuse in einem Stück, lässt sich das erfindungsgemäße Gehäuse einfach und kostengünstig herstellen.

In einer weiteren bevorzugten Ausführungsform der Erfindung ist das Kontaktelement aus einem korrosionsbeständigen, elektrisch leitfähigen Material hergestellt. Gerade im kraftfahrzeugtechnischen Bereich werden derartige Gehäuse mit korrosionshervorrufenden Substanzen in Berührung gebracht. Ein entsprechend korrosionsbeständiges Material erhöht vorteilhaft eine fehlerfreie Funktionalität des Kontaktelementes bzw. der Steckerschnittstelle.

Gemäß einer weiteren bevorzugten Ausführungsform der Erfindung ist das Gehäuse wannenförmig ausgebildet und weist mindestens eine Steckerschnittstelle im Boden des Gehäuses und/oder in der Gehäusewand auf. Die wannenförmige Ausgestaltung des Gehäuses ermöglicht aufgrund der geringen Bauhöhe vorteilhaft eine Anbringung des Gehäuses innerhalb eines Kraftfahrzeugs an räumlich beengten Stellen.

Herkömmlich verwendete Gehäuse weisen üblicherweise einen Rahmen auf, welcher oberhalb und unterhalb mittels jeweils eines Deckels und zugehöriger Dichtung verschlossen wird. Eine wannenförmige Ausgestaltung des Gehäuses ist somit besonders kostengünstig, da ein Deckel, z.B. der bodenseitige Deckel, mit entsprechender Dichtung sowie die zugehörige Montage für Deckel und Dichtung eingespart werden können.

Gemäß einer alternativen Ausführungsform der Erfindung weist das Gehäuse einen beidseitig offenen Rahmen auf, wie sie üblicherweise verwendet werden. Die erfindungsgemäße mindestens eine Steckerschnittstelle ist an der Innenwand des Rahmens angeordnet. Dadurch lässt sich die erfindungsgemäße Steckerschnittstelle vorteilhaft kostengünstig in herkömmliche Gehäuseformen integrieren.

In einer weiteren bevorzugten Ausführungsform der Erfindung ist die Steckerschnittstelle derart ausgestaltet, um eine Kontaktierung eines Aktuators zu ermöglichen. Eine derartige Ausgestaltung der Steckerschnittstelle ermöglicht vorteilhaft eine Steuerung von Aktuatoren, wie Magnetventilen und/oder Sensoren, innerhalb der Steuereinheit, bspw. einer elektrischen Druckluftaufbereitungseinheit eines Kraftfahrzeugs.

Gemäß einer weiteren bevorzugten Ausführungsform der Erfindung ist bzw. sind im Boden des Gehäuses ein oder mehrere Haltepins angeordnet. Diese Haltepins dienen zur Aufnahme der Leiterplatte und ermöglichen somit eine genaue Positionierung der Leiterplatte innerhalb des Gehäuses. Bevorzugt sind die Haltepins aus in Kunststoff eingegossenen Stiften gebildet, wobei die Stifte bei der Montage in dafür vorgesehene Löcher in der Leiterplatte gesteckt werden.

Die Erfindung löst o.g. Aufgabe ferner mit einem elektronischen Modul, insbesondere ein elektronisches Steuergerät für ein Kraftfahrzeug, mit einem Gehäuse und mit mindestens einer Leiterplatte zur Aufnahme von elektrischen Bauelementen, wobei das Gehäuse erfindungsgemäß entsprechend einer oder mehrerer vorstehend genannten Ausführungsformen ausgestaltet ist.

Die Verwendung eines erfindungsgemäßen Gehäuses zum Aufbau des elektronischen Moduls ermöglicht vorteilhaft eine einfache und kostengünstige Herstellung des elektronischen Moduls, wobei ein derartiges elektronisches Modul vorteilhaft besonders platzsparend ausgebildet ist, da ein zusätzlich angebrachter Stecker auf der Leiterplatte zur Herstellung einer Steckerschnittstelle entfällt. Ist die Steckverbindung bzw. der Stecker das einzige Bauteil auf einer Seite der Leiterplatte, so ist vorteilhaft eine einseitige Bestückung der Leiterplatte möglich, da die Steckerschnittstelle erfindungsgemäß in dem Gehäuse des elektronischen Moduls integriert ist.

Entsprechend einer bevorzugten Ausführungsform der Erfindung ist die Steckerschnittstelle des elektronischen Moduls derart ausgebildet, dass der erste Kontaktabschnitt des Kontaktelementes an der Leiterplatte kontaktiert ist, wobei die Kontaktierung bevorzugt mittels Einpresstechnik erfolgt. Die Einspresstechnik ermöglicht vorteilhaft eine lötfreie elektrische Verbindung bzw. Kontaktierung, indem der als Einpressstift ausgebildete Kontaktabschnitt des Kontaktelementes in ein Loch der Leiterplatte, welches durchkontaktiert ist, gepresst wird.

Die Erfindung löst die o. g. Aufgabe ferner mit einem Kraftfahrzeug, insbesondere einem Nutzfahrzeug, welches ein erfindungsgemäßes Gehäuse zur Aufnahme einer Leiterplatte aufweist und/oder ein erfindungsgemäßes elektronisches Modul aufweist.

Des Weiteren löst die Erfindung die o. g. Aufgabe mit einem Verfahren zum Herstellen eines erfindungsgemäßen Gehäuses, wobei mindestens ein Kontaktelement zur Herstellung der Steckerschnittstelle bei der Herstellung des Gehäuses mittels Gussverfahren in das Gehäuse eingelassen wird. Dabei besteht das Gehäuse bevorzugt aus einem nichtleitenden Werkstoff, insbesondere einem polymeren Werkstoff, und ist durch Spritzgießen hergestellt.

Durch das Einbringen des Kontaktelementes bzw. der Kontaktelemente in das Gehäuse bereits während des Herstellungsverfahrens des Gehäuses, ist vorteilhaft eine einfache und kostengünstige Herstellung der Steckerschnittstelle möglich.

Ist zudem das Kontaktelement gebogen ausgebildet, insbesondere U-förmig, V-förmig, W-förmig oder leicht winkelversetzt, ist eine besonders platzsparende Realisierung der Steckerschnittstelle in dem Gehäuse möglich.

Schließlich löst die Erfindung o. g. Aufgabe mit einem Verfahren zum Herstellen eines elektrischen Moduls, wobei die Leiterplatte bevorzugt mittels Einspresstechnik elektrisch an die Steckerschnittstelle angebunden wird. Je nach Anforderung kann jedoch die Verbindung von Leiterplatte und Steckerschnittstelle auch durch Löten oder Laserschweißen hergestellt werden.

Durch das Kontaktieren der Leiterplatte an die Steckerschnittstelle im Gehäuse ist ein separater Stecker auf der Leiterplatte nicht notwendig. Daher wirken keine Steck- und Ziehkräfte durch einen Stecker auf die Leiterplatte ein. Ferner entfallen vorteilhaft zusätzliche Material- und Prozesskosten, die durch eine Bestückung und Lötung eines Steckers auf die Leiterplatte anfallen würden.

Weitere Ausführungsformen der Erfindung ergeben sich aus den Ansprüchen sowie aus dem anhand der Zeichnung näher erläuterten Ausführungsbeispiel. In der Zeichnung zeigen:
- Fig. 1: einen Ausschnitt einer schematischen Schnittdarstellung eines erfindungsgemäßen Gehäuses mit Steckerschnittstelle und
- Fig. 2: eine schematische Darstellung einer Draufsicht einer erfindungsgemäßen Gehäusewanne.

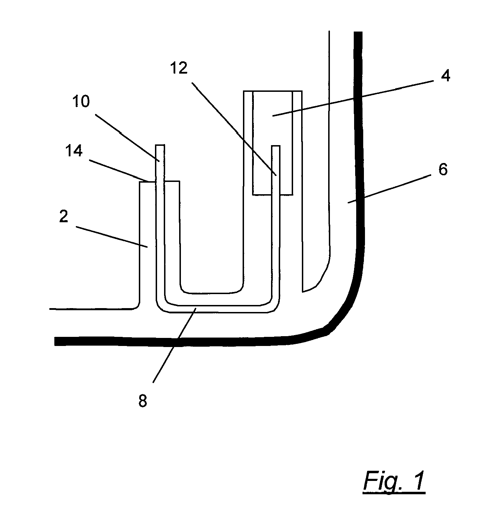

Fig. 1 zeigt einen Ausschnitt einer schematischen Schnittdarstellung einer erfindungsgemäßen Gehäusewanne. Ein Stützteil 2 sowie ein Steckergehäuse 4 sind einstückig mit der Gehäusewand 6 ausgebildet, wobei in dem Stützteil 2, dem Steckergehäuse 4 und einem Teilabschnitt der Gehäusewand 6 ein gebogenes Kontaktelement 8 eingebracht ist.

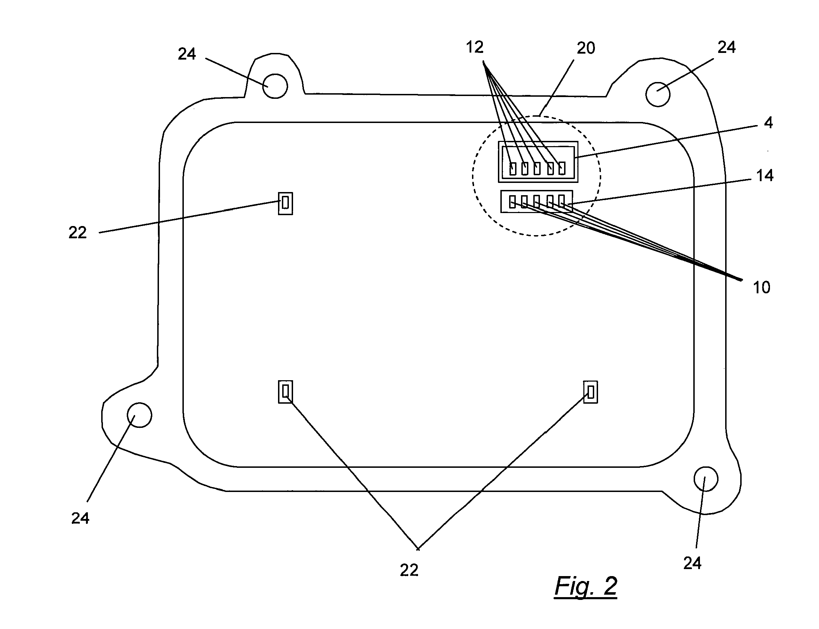

In dem in Fig. 1 und Fig. 2 dargestellten Ausführungsbeispiel der Erfindung ist das Kontaktelement U-förmig ausgebildet. Es sind jedoch auch V-förmige, W-förmige, leicht winkelversetzte oder ähnlich gebogene Kontaktelemente zur Ausgestaltung der Steckerschnittstelle denkbar. Dabei dient das Kontaktelement 8 als leitfähige Verbindungsleitung zwischen am Ende der Schenkel des Kontaktelementes 8 befindlichen Kontaktabschnitten 10, 12.

Ein erster Kontaktabschnitt 10 dient der elektronischen Anbindung an eine hier nicht dargestellte Leiterplatte und ist bevorzugt als Einpressstift ausgebildet. Dadurch lässt sich eine lötfrei arbeitende Einpresstechnik anwenden, bei der die anzuschließenden Einpressstifte in dafür vorgesehene metallisierte Bohrungen in der Leiterplatte gesteckt bzw. gepresst werden. Alternativ kann eine elektronische Anbindung des ersten Kontaktabschnittes 10 an die Leiterplatte auch durch Löten oder Schweißen erfolgen.

Im kontaktierten Zustand liegt die Leiterplatte auf einer Auflagefläche 14 des Stützteils 2 auf, wodurch sich vorteilhaft eine mechanische Halterung der Leiterplatte in dem Gehäuse ergibt. Dabei ermöglicht die Auflagefläche 14 eine gleichmäßige Einstecktiefe der Einpressstifte bei mehreren Kontaktelementen 8, wodurch eine sichere Kontaktierung auch bei äußeren Einflüssen, wie z.B. Vibrationen, entsteht. Dadurch ist das erfindungsgemäße Gehäuse besonders geeignet für Anwendungen im Automobilbereich.

Ein zweiter Kontaktabschnitt 12 des Kontaktelementes 8 ragt in ein Steckergehäuse 4 hinein, welches zur Aufnahme eines entsprechenden Gegensteckers zur Bildung einer elektrischen Steckverbindung ausgebildet ist. Über die Ausgestaltung des Steckergehäuses 4 lässt sich die Steckerschnittstelle an ein vorbestimmtes Steckerdesign der anzuschließenden elektrischen Komponente anpassen. Bevorzugt ist das Steckergehäuse 4 derart ausgestaltet, um eine kostengünstige und platzsparende Magnetkontaktierung innerhalb der Gehäusewanne eines Steuergerätes für eine elektronische Druckluftaufbereitungseinheit zu schaffen.

Die Steckerschnittstelle wird bevorzugt durch eine Mehrzahl vorstehend beschriebener, U-förmiger Kontaktelemente 8 gebildet, die voneinander isoliert nebeneinander und/oder hintereinander angeordnet sind, um bspw. eine Stiftleiste mit einer Mehrzahl an Kontakten herzustellen. Dabei können die Kontaktelemente 8 zur Bildung von speziellen Steckerdesigns verschiedene Schenkellängen aufweisen.

Fig. 2 zeigt eine schematische Darstellung einer Draufsicht einer erfindungsgemäßen Gehäusewanne mit einer erfindungsgemäßen Steckerschnittstelle 20.

Die Steckerschnittstelle 20 ist an dem Gehäuseboden angebracht bzw. einstückig mit dem Gehäuseboden ausgebildet und weist ein Steckergehäuse 4 und ein Stützteil 2 mit Auflagefläche 14 auf. Ferner sind in dem Steckergehäuse 4 die zweiten Kontaktabschnitte 12 und innerhalb der Auflagefläche 14 die ersten Kontaktabschnitte 10 dargestellt.

Ferner sind in der Gehäusewanne drei Haltepins 22 dargestellt. Die Haltepins 22 sind bevorzugt aus isolierendem Kunststoff gefertigt und weisen jeweils einen in dem Kunststoff eingegossenen Stift auf, welcher bei der Montage der Leiterplatte in ein dafür vorgesehenes Loch in der Leiterplatte gesteckt wird. Die Haltepins 22 erhöhen somit die mechanische Stabilität der Leiterplatte und gewährleisten eine sichere Positionierung der Leiterplatte innerhalb der Gehäusewanne.

Um die Gehäusewanne innerhalb eines Kraftfahrzeugs zu befestigen, weist die Gehäusewanne mehrere Befestigungslaschen 24 auf. Mittels der Befestigungslaschen 24 lässt sich die Gehäusewanne fixieren, bspw. durch Nieten oder Schrauben.

Zum Herstellen eines erfindungsgemäßen elektronischen Moduls, insbesondere eines Steuergerätes für Kraftfahrzeuge, wird auf den Haltepins 22 und der Auflagefläche 14 eine Leiterplatte befestigt, die mit den für die Steuerung notwendigen elektronischen Bauelementen bestückt ist. Um eine platzsparende, geringe Bauhöhe des elektronischen Moduls zu erzielen, ist die Leiterplatte bevorzugt einseitig bestückt.

Die Kontaktierung der Leiterplatte mit der Steckerschnittstelle 20 erfolgt über die Kontaktabschnitte 10, insbesondere mittels Einpresstechnik, wobei die Kontaktabschnitte 10 in dafür vorgesehene Löcher in der Leiterplatte gesteckt werden. Es enttällt gegenüber herkömmlichen Systemen ein separater Stecker an der Leiterplatte zum Herstellen einer Steckerschnittstelle.

Die Kontaktabschnitte 10 sind als U-förmig ausgebildete Kontaktelemente 8 mit den Kontaktabschnitten 12 der Steckerschnittstelle 20 verbunden, wobei die Kontaktabschnitte 12 innerhalb eines Steckergehäuses 4 liegen. Das Steckergehäuse 4 ist dabei derart ausgebildet, um einen entsprechenden Gegenstecker aufzunehmen, insbesondere zur Herstellung einer Magnetkontaktierung innerhalb des Steuergerätes.

Abschließend wird das elektronische Modul mit einem Deckel versehen, wobei eine zwischen der Gehäusewanne und dem Deckel angebrachte Dichtung das Modul abdichtet und somit vor äußeren Einflüssen schützt.

Aufgrund der erfindungsgemäßen Ausgestaltung der Steckerschnittstelle 20 mit einem oder mehreren U-förmigen Kontaktelementen 8, ist eine kostengünstige und platzsparende Kontaktierung von elektrischen Komponenten innerhalb des Gehäuses möglich. Die Einsparung eines Steckers auf der Leiterplatte ermöglicht ferner vorteilhaft eine Verwendung einer einseitig offenen Gehäusewanne.

Sämtliche in der vorstehenden Beschreibung sowie in den Ansprüchen genannten Merkmale sind erfindungsgemäß sowohl einzeln als auch in beliebiger Kombination miteinander einsetzbar. Die Offenbarung der Erfindung ist daher nicht auf die beschriebenen bzw. beanspruchten Merkmalskombinationen beschränkt. Vielmehr sind alle Kombinationen von Einzelmerkmalen als offenbart zu betrachten.

## Patentansprüche

1. Gehäuse zur Aufnahme einer Leiterplatte mit mindestens einer Steckerschnittstelle (20) für eine elektronische Anbindung der Leiterplatte an mindestens eine elektrische Komponente,
**gekennzeichnet durch**
eine Anbringung der Steckerschnittstelle (20) an eine Innenwand (6) des Gehäuses und
eine Ausgestaltung der Steckerschnittstelle (20) mit mindestens einem Kontaktelement (8) mit zwei Kontaktabschnitten (10; 12), wobei der erste Kontaktabschnitt (10) der elektronischen Anbindung an die Leiterplatte dient und der zweite Kontaktabschnitt (12) einen Stecker bildet.

2. Gehäuse nach Anspruch 1,
**dadurch gekennzeichnet, dass**
mindestens ein Kontaktabschnitt (10; 12) des Kontaktelementes (8) als Kontaktstift ausgebildet ist.

3. Gehäuse nach Anspruch 1 oder 2,
**dadurch gekennzeichnet, dass**
der erste Kontaktabschnitt (10) des Kontaktelementes als Einpressstift ausgebildet ist.

4. Gehäuse nach einem der vorhergehenden Ansprüche
**gekennzeichnet durch**,
eine Ausgestaltung der Steckerschnittstelle (20) mit einem elektrisch nicht leitenden Stützteil (2), in welchem der erste Kontaktabschnitt (10) des Kontaktelementes (8) angeordnet ist, wobei das Stützteil (2) eine Auslagefläche (14) zur Auflage der Leiterplatte aufweist und
eine weitere Ausgestaltung der Steckerschnittstelle (20) mit einem elektrisch nicht leitenden Steckergehäuse (4) in welchem der zweite Kontaktabschnitt (12) des Kontaktelementes (8) angeordnet ist.

5. Gehäuse nach Anspruch 4,
**dadurch gekennzeichnet, dass**
das Stützteil (2) und das Steckergehäuse (4) einstückig mit dem Gehäuse ausgebildet sind.

6. Gehäuse nach einem der vorhergehenden Ansprüche,
**dadurch gekennzeichnet, dass**
das Kontaktelement (8) aus einem elektrisch leitenden Material hergestellt ist.

7. Gehäuse nach einem der vorhergehenden Ansprüche,
**dadurch gekennzeichnet, dass**
das Gehäuse wannenförmig ausgebildet ist und die mindestens eine Steckerschnittstelle (20) im Boden des Gehäuses und/oder in der Gehäusewand angeordnet ist.

8. Gehäuse nach einem der Ansprüche 1 bis 6,
**dadurch gekennzeichnet, dass**
das Gehäuse einen beidseitig offenen Rahmen aufweist und die mindestens eine Steckerschnittstelle (20) an der Innenwand des Rahmens angeordnet ist.

9. Gehäuse nach einem der vorhergehenden Ansprüche,
**gekennzeichnet durch**
eine Ausgestaltung der Steckerschnittstelle (20) zur Herstellung einer Kontaktierung eines Aktuators, insbesondere eine Magnetkontaktierung und/oder eine Kontaktierung eines Sensors.

10. Gehäuse nach einem der vorhergehenden Ansprüche,
**gekennzeichnet durch**
ein oder mehrere im Boden des Gehäuses angeordnete Haltepins (22) zur Aufnahme der Leiterplatte.

11. Elektronisches Modul, insbesondere ein Steuergerät für Kraftfahrzeug, mit einem Gehäuse und mit mindestens einer Leiterplatte zur Aufnahme von elektrischen Bauelementen,
**dadurch gekennzeichnet, dass**
das Gehäuse nach einem der Ansprüche 1 bis 9 ausgebildet ist.

12. Elektronisches Modul nach Anspruch 10,
**dadurch gekennzeichnet, dass**
der erste Kontaktabschnitt (10) des Kontaktelementes (8) an der Leiterplatte kontaktiert ist und die Kontaktierung mittels Einpresstechnik erfolgt.

13. Kraftfahrzeug, insbesondere Nutzfahrzeug,
**gekennzeichnet durch**
ein Gehäuse zur Aufnahme einer Leiterplatte nach einem der Ansprüche 1 bis 9 und/oder
ein elektronisches Modul nach einem der Ansprüche 10 oder 11.

14. Verfahren zum Herstellen eines Gehäuses zur Aufnahme einer Leiterplatte nach einem der Ansprüche 1 bis 9,
**dadurch gekennzeichnet, dass**
mindestens ein Kontaktelement (8) zur Herstellung der Steckerschnittstelle (20) bei der Herstellung des Gehäuses in das Gehäuse integriert wird.

15. Verfahren zur Herstellung eines elektronischen Moduls nach einem der Ansprüche 10 oder 11,
**dadurch gekennzeichnet, dass**
die Leiterplatte mittels Einpresstechnik elektrisch an die Steckerschnittstelle (20) angebunden wird.
